# EUROPEAN PATENT APPLICATION

(11) **EP 1 736 827 A1**
(43) Date of publication of application: **27.12.2006**
(21) Application number: 05720175.8
(22) Date of filing: 07.03.2005
(51) Int. Cl.: G03F 7/039

(54) **POSITIVE RESIST COMPOSITION FOR IMMERSION EXPOSURE AND METHOD FOR FORMING RESIST PATTERN**

(30) Priority: 05.03.2004 JP 2004063016; 08.06.2004 JP 2004170424
(71) Applicant: TOKYO OHKA KOGYO CO., LTD., Kawasaki-shi, Kanagawa 211-0012 (JP)
(72) Inventor: ISHIDUKA, Keita, c/o TOKYO OHKA KOGYO CO., LTD., Kawasaki-shi, Kanagawa 2110012 (JP); ENDO, Kotaro, c/o TOKYO OHKA KOGYO CO., LTD., Kawasaki-shi, Kanagawa 2110012 (JP)
(74) Representative: Perin, Georges
(86) International application number: PCT/JP2005/003903
(87) International publication number: WO 2005/085954

(57) **Abstract**

The present invention relates to a positive-type resist composition for liquid immersion lithography and a method of forming a resist pattern, in particular, a positive-type resist composition for liquid immersion lithography that exhibits superior liquid immersion resistance to water; and a method for forming a resist pattern by thereof. The positive-type resist composition for liquid immersion lithography according to the present invention includes a resin component (A) increasing alkali-solubility by acid action; and an acid generator generating acid by exposure; in which, the resin component (A) contains at least one acrylic ester constitutional unit (a1), and one (meth)acrylic ester constitutional unit (a2) having acid dissociable, dissolution inhibiting group, and the constitutional unit (a1) consists of a cyclic group bonded to the acrylic ester of the constitutional unit (a1), and a fluoro organic group bonded to the cyclic group.

## Description

### TECHNICAL FIELD

The present invention relates to a positive-type resist composition for liquid immersion lithography and a method of forming a resist pattern, in particular, a positive-type resist composition for liquid immersion lithography that exhibits superior liquid immersion resistance to an immersion liquid, such as water, and a method for forming the resist pattern by using thereof.

### BACKGROUND ART

Conventionally, lithography has been commonly used in fabricating fine structures in various kinds of electronic devices such as semiconductor devices and liquid crystal devices. However, along with the miniaturization of device structures, there is a need for micro-fabrication of resist patterns in a lithography process. Even though, in the most advanced areas nowadays, for example, lithography methods using an ArF excimer laser can form a fine resist pattern, which has a line width of about 90 nm, a finer pattern configuration will be desired in future. To achieve micro-fabrication of patterns with line widths finer than 90 nm, the success of the development of a photolithography machine, and the resists suitable for such a machine are the most important key. The improvement of the exposure system generally consists of a light source, such as: an F₂ excimer laser, an EUV (extreme ultraviolet) light, an electron beam, or an X-ray, having a shorter wavelength, and a lens having an increased numerical aperture (NA), expands the aperture, and the like. On the other hand, not only does shortening the wavelengths of the light sources require a new and expensive photolithography machine, but also a problem arises when increasing the NA; in that a focal depth width is reduced even if the resolving ability is improved, because a trade-off lies between increasing the resolving ability and the focal depth width.

To deal with this problem, the method called "immersion lithography" is reported. (For example, see the non-patent documents 1, 2, and 3). Conventionally, in this method, liquid, such as pure water and fluorocarbon inert liquid, which has a higher refractive index than inert gas, such as air and nitrogen, is filled between a lens and a resist layer on a wafer. Thus, even if the same light source is used, the resolving ability is increased and the focal depth range is decreased, as a light source with shorter wavelength, or a high NA lens is used. This type of liquid immersion lithography is attracting a lot of attention, which enables resist patterns with a higher resolving ability and satisfactory focal depth to be formed at a lower cost, even if the lens attached to the conventional machine is used.
Non-patent Document 1: Journal of Vacuum Science & Technology B (J.Vac.,Sci.Technol.B)(Published in USA), 1999, Vol.17, No.6, pp.3306-3309
Non-patent Document 2: Journal of Vacuum Science & Technology B (J.Vac.Sci.Technol.B)(Published in USA), 2001, Vol.19, No.6, pp.2353-2356
Non-patent Document 3: Proceedings of SPIE Vol.4691 (Published in USA), 2002, Vol.4691, pp.459-465

### DISCLOSURE OF THE INVENTION

In immersion lithography, exposure is conducted, in which immersion liquid, such as pure water and fluorocarbon inert liquid, which has a higher refractive index than air, is filled into a resist layer on a wafer, so that a resist composition film is directly exposed to the immersion liquid. Therefore, in (liquid) immersion lithography, the development of a resist composition for liquid immersion lithography which has resistance to liquid immersion lithography without a negative impact on the formation of a resist pattern, even when exposed to an immersion liquid, has become a problem. Furthermore, a composition applied to the lithography should have a higher barrier property between an immersion liquid and a resist film, which means that contact angle, is higher for the immersion liquid. When the resist layer is in contact with the immersion liquid during the exposure, the immersion lithography has problems in that the resist layer properties are degenerated, or the resist component is dissolved in the immersion liquid to change the refractive index of the immersion liquid, which adversely affects the immersion liquid. In general, it is thought that a resin having a fluorine atom is used as means to increase the contact angle. Actually, however, when a specific resin having a fluorine atom is used to conduct a simulated immersion lithography treatment described hereinafter, the resist is affected from the immersion liquid, the sensitivity deteriorates, and the surface of the resist pattern becomes rough, which means that the obtained resist pattern has a T-top formation (profile deformation).

The object of the present invention, based on the abovementioned example, is to provide a positive-type resist composition for liquid immersion lithography and a method for forming a resist pattern. In particular, the object of the present invention, is to provide a positive-type resist composition having resistance to immersion solvent with a superior barrier property towards water, and a superior resist pattern profile configuration, and a method for forming a resist pattern thereof.

Considerable research with reference to the resist resins included in a positive-type resist composition has been carried out to solve the problem, and it has been found that a resist resin having a specific constitutional unit exhibits a resistance to immersion solvent with a superior barrier property towards water, without deterioration in sensitivity; and a superior resist pattern profile configuration in liquid immersion lithography, so as to achieve the present invention.

In other words, a positive-type resist composition for liquid immersion lithography according to the present invention includes: a resin component (A), increasing alkali-solubility by acid action; and an acid generator, generating acid by exposure; in which, the resin component (A) contains at least: one acrylic ester constitutional unit (a1); and one methacrylic ester constitutional unit (a2) having an acid dissociable, dissolution inhibiting group; and the constitutional unit (a1) consists of: a cyclic group bonded to an acrylic ester of the constitutional unit (a1); and a fluoro organic group bonded to a cyclic group; and the fluoro organic group is formed by at least partially substituting hydrogen atoms of the organic group with fluorine atoms, and has a substituted or unsubstituted alcoholic hydroxyl group.

The constitutional unit (a1) of the positive-type resist composition for liquid immersion lithography according to the present invention is expressed by the general formula (1) below.

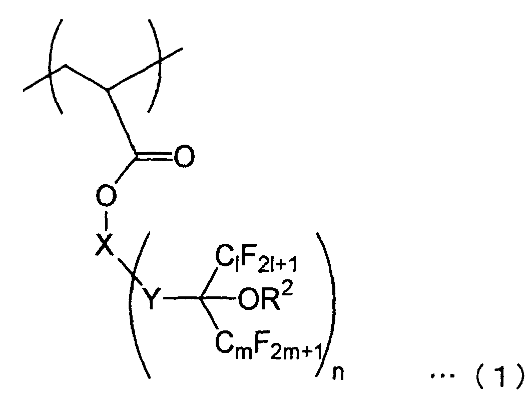

In the formula, X represents a divalent or trivalent cyclic group. R² represents a hydrogen atom, a chain, a branched or a cyclic alkyloxymethyl group with 1 to 15 carbons. 1 and m respectively, are integers from 1 to 5, and n is an integer of 1 or 2.

The cyclic group is preferably an aliphatic ring group. The aliphatic cyclic group is preferably a monocyclic aliphatic hydrocarbon group or a polycyclic aliphatic hydrocarbon group. The monocyclic aliphatic hydrocarbon group is preferably a group in which 2 to 3 hydrogen atoms are removed from cyclohexane. The polycyclic aliphatic hydrocarbon group is preferably a group in which 2 to 3 hydrogen atoms are removed from norbornane.

In the positive type-resist composition for liquid immersion lithography according to the present invention, the constitutional unit (a2) is expressed by the general formula (2) below.

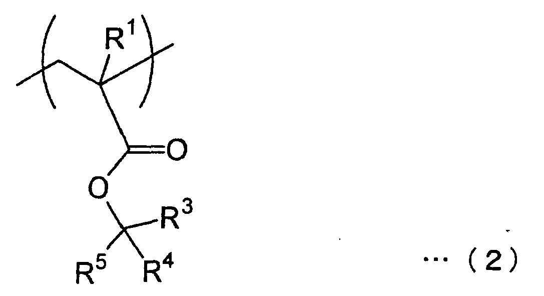

In the formula, R¹ represents a hydrogen atom or a methyl group. R³ to R⁵ represents an alkyl group having 1 to 10 carbons, and may be the same or different from each other. In addition, at least two alkyl groups among these may form the same cyclic group. The acid dissociable, dissolution inhibiting group is preferably a polycyclic aliphatic hydrocarbon group, more preferably an adamanthyl group.

The resin component (A) in the positive-type resist composition for liquid immersion lithography according to the present invention includes one or more constitutional units (a3), being different from the constitutional units (a1) and (a2). The constitutional unit (a3) is preferably induced from a (meth)acrylic ester having lactone, and more preferably the constitutional unit (a4) is induced from a (meth)acrylic ester having a monocyclic or polycyclic group with lactone. In addition, the constitutional unit (a3) is preferably the constitutional (a7) expressed by the general formula (3) below.

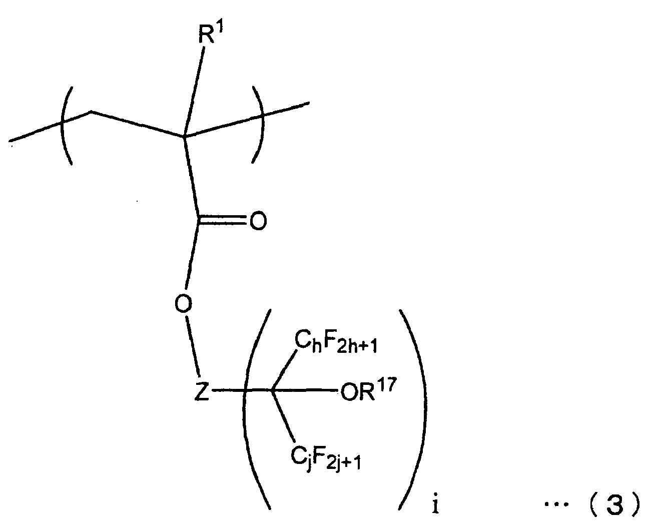

In the formula (3), Z represents a divalent or trivalent cyclic group. R¹ represents a hydrogen atom or a methyl group. R¹⁷ represents a hydrogen atom, a chain, a branched or a cyclic alkyloxymethyl group having 1 to 15 carbons. h and j respectively, are integers from 1 to 5, and i is an integer of 1 or 2.

For the positive-type resist composition for liquid immersion lithography according to the present invention, the medium for liquid immersion lithography is water.

The method of forming a resist pattern is a method for forming a resist pattern using a liquid immersion lithography process which includes the steps of: forming a photoresist film onto a substrate by using the positive-type resist composition; disposing an immersion liquid onto the substrate on which the resist film is laminated; selectively exposing the resist film via the immersion liquid; conducting a heat process as required; and developing the resist film.

The positive-type resist composition for liquid immersion lithography according to the present invention exhibits liquid immersion resistance, so that it can be used to obtain a resist pattern having a higher resolving ability by way of liquid immersion lithography. In particular, this resist composition exhibits a superior barrier property to water, so that a resist pattern can be provided which has a higher resolving ability, by way of liquid immersion lithography using water as an immersion liquid.

### PREFERRED MODE FOR CARRYING OUT THE INVENTION

Preferred modes of the present invention will be explained in the following. The positive-type resist composition for liquid immersion lithography according to the present invention includes: the resin component (A), increasing alkali-solubility by acid action; and the acid generator (B), and generating acid by exposure. In the positive-type resist composition for liquid immersion lithography, the resin component (A) contains at least: one acrylic ester constitutional unit (a1), and one methacrylic ester constitutional unit (a2) having acid dissociable, dissolution inhibiting group. The constitutional unit (a1) consists of a cyclic group bonded to the acrylic ester of the constitutional unit (a1), and a fluoro organic group bonded to the cyclic group. The fluoro organic group is formed by at least partially substituting hydrogen atoms of the organic group with fluorine atoms, and has a substituted or unsubstituted alcoholic hydroxyl group. In the positive-type resist composition for liquid immersion lithography according to the present invention, the resin component (A) consists of the specific constitutional units (a1) and (a2), so that it has a higher contact angle for the immersion liquid. Thus, the resist composition has superior liquid immersion resistance. In particular, it exhibits a superior barrier property towards water, so that a resist pattern, which has a higher resolving ability, can be provided by way of liquid immersion lithography using water as an immersion liquid. The water repellent property of the resist composition increases by having a higher contact angle. That means that the barrier property is superior towards water, resulting in preventing various components, such as an acid generator, nitrogen-containing compound, and a surfactant of the resist film from being extracted from the resist film. In the photoresist composition for F₂ lithography, the transparency of a photoresist film having a (meth)acrylic ester constitutional unit decreases. However, the positive-type resist composition for liquid immersion lithography is preferred for ArF lithography to obtain a resist pattern having a higher resolving ability.

For evaluating the formation of a resist pattern by liquid immersion lithography (sometimes referred as "immersion lithography"), it is considered necessary to confirm three points below.
(i) The performance of the optical system in the immersion lithography process
   As known, for example, in cases where it is assumed that a photosensitive plate, of which the surface is water-proof, for photograph is immersed into water and a patterning light beam is irradiated onto the surface. In principle, it is undoubted with respect to the factor of the performance of an optical system that no problem occurs if no loss in light propagation occurs on the water surface, and at the interface between the water and the surface of the photosensitive plate. In this case, a problem of loss in light propagation may be easily solved, simply by suitably correcting the incidence angle of the exposing light beam. Accordingly, regardless of the resist film, the photosensitive plate for the photograph, and the imaging screen being exposed, the optical system is insensitive to the immersion solvent, namely it is not affected by the immersion solvent and vice versa. Thus, it is not necessary to further confirm this factor or conduct an experiment on it, so that no deterioration occurs in the performance of the optical system.
(ii) The effect of the resist film on the immersion solvent (sometimes referred as "immersion liquid")
   The effect of the resist film on the immersion solvent specifically indicates that the component of the resist film is dissolved in the immersion solvent to change the refractive index of the solvent. Theoretically, if the refractive index of the immersion solvent changes, the optical resolving ability of the pattern exposure is sure to change. This factor may be sufficiently confirmed simply by verifying that a component has been dissolved from the resist film into the immersion solvent, or the refractive index has changed when the resist film is immersed into the immersion solvent. Therefore, it is not necessary that a patterning light beam is irradiated and then the resist film is developed to check the resolving ability. Conversely, when the resist film immersed in the liquid is irradiated with a pattern light and developed, it is possible to know as to whether or not the resolving ability is excellent or poor. However, it is difficult to determine whether the resolving ability is affected by the degeneration of immersion solvent, the resist material, or both.
(iii) The degeneration of the resist film due to the immersion solvent
   With respect to the phenomenon in which the resolving ability is lowered by the change of properties of the resist film due to the immersion solvent, an evaluation test described below. The immersion solvent is poured on the resist film between the process of the selective exposure and the post-exposure baking (PEB), for example in the form of a shower, for bringing into contact with the resist film, followed by developing the resist film to test the resolving ability of the resulting resist patterns. In this evaluation method, the resist film is directly showered with the solvent, and hence the conditions for immersion are very stringent. In this point, by a test in which the resist film completely immersed in the solvent is exposed, it is difficult to determine whether the resolving ability is changed from the degeneration of the immersion solvent, the resist composition from the immersion solvent, or both.
   The abovementioned factors (ii) and (iii) are inextricably linked and therefore, both of them may be recognized by verifying the degree of degeneration of the resist pattern or the sensitivity caused by the liquid immersion solvent. In other words, checking point (iii) simultaneously checks point (ii). Based on these analyses, resist films, which are preferably used for immersion lithography, are evaluated for their aptitude for liquid immersion lithography by way of the evaluation test (hereinafter, referred to as "Evaluation Test 1",) described below. The immersion solvent is poured like a shower on the resist film between the process of selective exposure and the process of post-exposure baking (PEB), for bringing into contact with the film, followed by developing the resist film to make a test on the resolving ability of the resulting resist pattern. Furthermore, in another evaluation test (hereinafter, referred to as "Evaluation Test 2," as another evaluation method corresponding to the advanced method of Evaluation Test 1, the resolving ability is determined by way of a two-beam interferometry exposure method. The practical production process can be simulated by using an interfered light, caused by a prism, as a pattern light for exposure to subject a sample immersed in the immersion solvent to exposure. The Evaluation Test 2 is disclosed in the Non-patent document 2, which is known as a method by which a line and space pattern (sometimes referred as "L&S") can be easily obtained in a laboratory scale.
   In Evaluation Test 1, a resist pattern with a 130 nm 1:1 line-and-space pattern is formed to measure the sensitivity (X1) by way of a normal exposure lithography process using a 193 nm light source. A simulated immersion lithography process, in which the immersion solvent is in contact with the resist film during the selective exposure and the post exposure bake (PEB), and is followed by the normal exposure lithography process, conducted to form the resist pattern, and then measure the sensitivity (X2). It is required that the absolute value of [(X2/X1)-1]×100 is 4 or less, preferably 3 or less, more preferably 2 or less, and most preferably from 0 to 1.5. In addition, when X1 and X2 are equivalent, the resist component is less rendered to satisfy a resist pattern profile. The normal exposure lithography process using a 193 nm light source has been a conventional process. In this lithography process, an ArF excimer laser having a wavelength of 193 nm as a light source is used to expose a substrate, such as a silicon wafer, in which a space between the lens of an exposure system and a resist film on a wafer is filled with inert gas, such as air or nitrogen gas, and then the substrate is subjected to a general lithography process, namely, successively subjected to a resist coating, prebake, selective exposure, post exposure bake, and alkaline development. The process optionally comprises a post-bake step after the alkaline development. An organic or inorganic anti-reflective coating film can be formed between the substrate and the coating layer of the resist composition.

The sensitivity X1 with which a resist pattern having a 130 nm 1:1 line-and-space (hereinafter, referred to as "130 nm L&S") is the exposure amount, which is obviously and frequently used by those skilled in the art.

The sensitivity X1 is calculated as follows. First, the exposure energy is taken as the abscissa and a resist line width formed at the exposure energy is taken as the ordinate, and a logarithmic approximation curve is obtained from the resultant plot by a method of least squares. The curve is given by the formula: Y=aLoge(X1)+b. In the formula, X1 represents exposure energy, Y represents a resist line width, and a and b each represent a constant. This formula is converted to Xl=Exp[(Y-b)/a] to represent X1. Y=130 (nm) is applied to this formula to obtain an arithmetically ideal sensitivity X1.

The conditions, that is, the number of revolutions of the resist coating, the prebake temperature, the exposure conditions, the post exposure bake conditions, and the alkaline development conditions may be conditions commonly used, which are obvious, such that a 130 nm L&S can be formed. Specifically, a silicon wafer with an 8 inch diameter is used. The number of revolutions is about 1,000 to 4,000 rpm, more specifically about 2,000 rpm. The prebake temperature is from 70 to 140 degrees C, more specifically 90 to 110 degrees C for 90 seconds. In this condition, a resist coating film, in which the thickness is 80 to 250 nm, more specifically 150 to 250 nm, and the diameter is 6 inches, is formed in a concentric circle on the substrate. In exposure conditions, in which an 193 nm wave length ArF excimer laser exposure system manufactured by Nikon Corporation or Canon Inc. (NA=0.60), etc., specifically NSR-S302B manufactured by Nikon Corporation (NA (numerical aperture)=0.60, 2/3 annular illumination) is used, the resist film is exposed through a mask. As a mask in the selective exposure, a general binary mask, or a phase shift mask may be used. Post exposure bake is conducted at 70 to 140 degrees C, more specifically 90 to 100 degrees C, for 90 seconds. Alkaline development conditions are such that, development is conducted using a 2.38 mass% TMAH (tetramethylammonium hydroxide) developer solution at 23 degrees C for 15 to 90 seconds, followed by rinsing with water.

In addition, a simulated immersion lithography process is a process, in which the immersion solvent is in contact with the resist film during the selective exposure and post exposure bake (PEB) in the normal exposure lithography process using 193 nm ArF excimer laser of light source.

Specifically, the process may include a process of resist coating, prebake, selective exposure to bring the resist film into contact with a solvent, post exposure bake, and alkaline development for immersion lithography. The process optionally includes a post-bake step after the alkaline development. When the resist film, which is disposed on a substrate after the selective exposure, is immersed in an immersion solvent, the immersion solvent may be dripped or showered with a nozzle onto the resist film. The temperature is 23 degrees C, and the number of revolutions of the substrate is 300 to 3000 rpm, preferably 500 to 2500 rpm. The condition in which the resist film is in contact with an immersion solvent is described as follows. Pure water is sprayed onto a substrate by a rinsing nozzle while a wafer with the resist film exposed is rotated. The number of revolutions is 500 rpm, the solvent is pure water, the amount of solvent sprayed is 1.0 L/min, the period for the solvent sprayed is 2 minutes, and the temperature for the contact of resist with the solvent is 23 degrees C. Afterwards, the sensitivity X2, which is determined when a 130 nm L&S resist patter is formed in the simulated immersion lithography process, is equivalent to the sensitivity X1, which is generally used by those skilled in the art. In addition, other conditions to calculate the sensitivity X2, are the same as that of sensitivity X1. In other words, the conditions, in which the sensitivity X2 is determined, is the same conditions in which the sensitivity X1 is determined, except that the solvent for immersion exposure is in contact with the resist film.

The term "(meth)acrylic acid" as used herein means methacrylic acid, acrylic acid, or both. The term "constitutional unit" as used herein means a monomer unit that forms a polymer. In addition, the term "exposure" as used herein also means includes "electron-beam printing".

In the positive-type resist composition for liquid immersion lithography according to the present invention, the resin component (A) having an acid dissociable, dissolution inhibiting group is alkaline-insoluble. However, the resin component turns to alkaline solubility, when acid is generated from the acid generator component (B), by way of exposure, to dissociate an acid dissociable, dissolution inhibiting group. For this reason, in the formation of a resist pattern, when the positive resist composition applied to a substrate is selectively exposed through a mask pattern, the alkali-solubility of the exposed portion increases, enabling alkaline development. Resin Component (A)

In the positive-type resist composition according to the present invention, the resin component (A) contains at least: one acrylic ester constitutional unit (a1), and one methacrylic ester constitutional unit (a2) having acid dissociable, dissolution inhibiting group without limitation. In the positive-type resist composition for liquid immersion lithography according to the present invention, the resin component (A) may be used as a binary resin that contains at least: one acrylic ester constitutional unit (a1), and one methacrylic ester constitutional unit (a2) having an acid dissociable, dissolution inhibiting group. To improve characteristics such as the resolving ability, the component (A) is applied for exposure by way of an ArF excimer laser. The component (A) preferably includes 80 mol% or more, more preferably 90 mol% or more of a constitutional unit induced from (meth)acrylic ester, most preferably 100 mol%. The resin component (A) may be used in a tertiary, quaternary or greater resin structure that includes one or more constitutional units (a3), being different from the constitutional units (a1) and (a2). By using this kind of tertiary or quaternary resin structure, the resin component (A) improves in resolving ability, dry etching resistance, and micro pattern configuration.

The constitutional unit (a3) other than the constitutional units (a1) and (a2) formed by the tertiary, quaternary or greater resin structure that includes: a constitutional unit (hereinafter referred as "(a4)" or "unit (a4)"), which is induced from a (meth)acrylic ester having a lactone unit; structural units derived from a (meth)acrylate having an alcoholic hydroxyl group-containing polycyclic group (hereinafter referred to as "(a5)" or "unit (a5)"); and structural units containing a polycyclic group that differs from any of the acid-dissociative anti-dissolving group of the units (a1) and (a2), the lactone unit of the unit (a4) and the alcoholic hydroxyl group-containing polycyclic group of the unit (a5) (hereinafter referred to as "(a6)" or "unit (a6)"). The term "lactone unit" herein is referred to as a group, in which one hydrogen atom is removed from a monocyclic or polycyclic lactone.

(a4), (a5), and/or (a6), which are the components of (a3) may be combined, if applicable depending on the needed characteristics or the like. The component (A) preferably includes the units (a1), (a2) and (a3), so that the resist components have a higher dissolution resistance in the solvent (immersion liquid), which is used in the (liquid) immersion lithography process, and a superior resist pattern configuration. 40 mol% or more, more preferably 60 mol% or more, of these three constitutional units is preferably included in the component (A). Alternatively, among the units (a1) to (a6), different kinds of units may be combined and used.

### Unit (a1)

The acrylic ester constitutional unit (a1) of the component A in the positive-type resist composition according to the present invention comprises a cyclic group bonded to an acrylic ester of the constitutional unit (a1), and a fluoro organic group bonded to the cyclic group. The fluoro organic group is formed by at least partially substituting hydrogen atoms of the organic group with fluorine atoms, and has a substituted or unsubstituted alcoholic hydroxyl group.

In addition, the constitutional unit (a1) is preferably the constitutional expressed by the general formula (1) below. In the formula (1), X represents a divalent or trivalent cyclic group, and Y represents a divalent alkylene or alkyloxy group having 1 to 6 carbons. R² represents a hydrogen atom, a chain, a branched or a cyclic alkyloxymethyl group having 1 to 15 carbons. 1 and m respectively, are integers from 1 to 5, and n is an integer of 1 or 2.

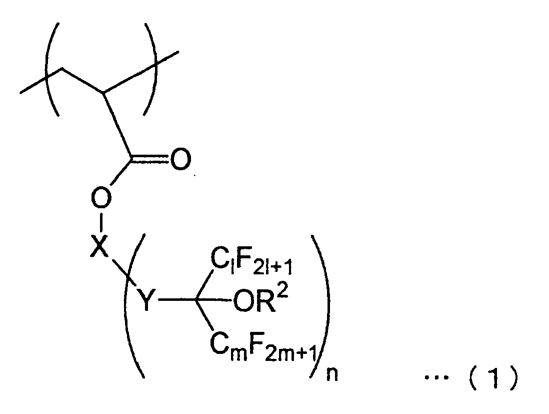

In the unit (a1), the cyclic group is a divalent or trivalent cyclic group, which binds an oxygen atom of an acrylic ester in the unit (a1), and has one or two fluorinated organic groups in its ring. In the general formula (1), a divalent or trivalent cyclic group expressed by X includes an aliphatic or aromatic cyclic group, without any limitations in particular. Among these, an aromatic cyclic group may be used in the photoresist composition for KrF exposure. To improve transparency, an aliphatic ring formula is preferably used, in particular, in the photoresist composition for ArF exposure. In the general formula (1), hydrogen atoms of acrylic ester main chain are not expressed.

For the aromatic cyclic group, various monocyclic or polycyclic divalent or trivalent aromatic cyclic groups may be used without any limitations in particular. Examples of aliphatic cyclic hydrocarbons, which may be used as this kind of aromatic cyclic group, include benzene, naphthalene, anthracene and the like.

For the aliphatic cyclic group, various monocyclic or polycyclic divalent or trivalent aliphatic cyclic groups may be used without any limitations in particular. Examples of aliphatic cyclic hydrocarbons, which may be used as this kind of aliphatic cyclic group, include a monocyclic aliphatic cyclic group such as cyclohexane, cyclopentane, and a polycyclic aliphatic cyclic hydrocarbon. An aliphatic cyclic group is used by removing two or three hydrogen atoms from these carbon hydrides. Among these, polycyclic aliphatic hydrocarbon is preferred, and includes, for example, adamantane, norbornane, norbornene, methylnorbornane, ethylnorbornane, methylnorbornene, ethylnorbornene, isobornane, tricyclodecane, tetracyclododecane, and the like. In the ArF resist, any of these polycyclic hydrocarbons may be appropriately selected to be used. Among these, adamantane, norbornane, norbornene, methylnorbornane, ethylnorbornane, methylnorbornene, ethylnorbornene, tetracyclododecane are preferred for industrial use, and norbornane is more preferred.

The fluoro organic group of the unit (a1) is formed by at least partially substituting hydrogen atoms of the organic group with fluorine atoms, and has a substituted or unsubstituted alcoholic hydroxyl group. In addition, one or more fluorinated organic groups bind to the cyclic group. Introducing a substituted or unsubstituted fluorinated alcohol in an organic group improves the transparency of the photoresist composition.

As the general formula (1) shows, the fluorinated organic group is preferably an alcoholic hydroxyl group in which the carbon atom of the branched chain, which is adjacent to the carbon atom binding to the substituted or unsubstituted alcoholic hydroxyl group, has at least one fluorine atom. In this case, the number of carbon atoms in the branched chain is from 1 to 5.

In the general formula (1), a group expressed by Y in the fluorinated organic group represents a divalent alkylene or alkyloxy group with 1 to 6 carbons. These alkylene groups include, for example, a methylene group, an ethylene group, and a propylene group, preferably a methylene group. Specific examples of the alkyloxy groups include a methyloxy group, an ethyloxy group, and a propyloxy group, preferably a methyloxy group.

In the unit (a1), the alcoholic hydroxyl group having the fluorinated organic group may be an unsubstituted alcohol, or an alcohol substituted by a protective group. This protective group acts as an acid dissociable, dissolution inhibiting group increasing alkali-solubility of the resin component (A) by acid action. The unit (a1) has this acid dissociable, dissolution inhibiting group, so that the resist composition exhibits dissolution suppression function to alkali development before exposure and alkaline-solubility by deprotection after exposure or PEB, resulting in an alkaline-solubility that is widely varied between before and after exposure. Therefore, the film loss of the resist pattern formed is prevented to obtain a micro pattern having a superior resolving ability.

The protective group, in which R² is not a hydrogen atom in the general formula (1), is preferable a chain, a branched or a cyclic alkyloxymethyl group with 1 to 15 carbon atoms, in terms of acid dissociation performance; and in particular, preferably a lower alkoxymethyl group, such as a methoxymethyl group, because of a higher resolving ability and superior pattern configuration. The rate of the acid dissociable, dissolution inhibiting group is 10 to 40%, preferably 15 to 30% based on entire alcoholic hydroxyl groups from the viewpoint of excellent pattern-forming ability. Unit (a2)

The (meth)acrylic ester constitutional unit (a2) in the component (A) of the positive-type resist composition according to the present invention, has an acid dissociable dissolution inhibiting group bonded to the (meth)acrylic ester (a2). In the positive-type resist composition for liquid immersion lithography according to the present invention, the resin component (A) is an alkali-insoluble resin having a so-called acid-dissociative dissolution controlling group, and when acid is generated from the acid generator component (B) by exposure, the acid causes the acid-dissociative dissolution controlling group to dissociate, making the resin component alkali-soluble. For this reason, in the formation of the resist pattern, when the positive resist composition applied to a substrate is selectively exposed through a mask pattern, the alkali-solubility of the exposed portion increases to enable alkaline development.

The unit (a2) represented by the following general formula (2) is preferable. In the formula (2), R¹ represents a hydrogen atom or a methyl group. R³ to R⁵ represents an alkyl group having 1 to 10 carbons, which may be the same or different from each other. In addition, at least two alkyl groups among these may form the same cyclic group.

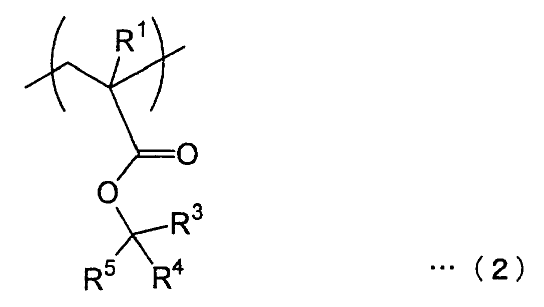

Any groups, which have an alkaline dissolution inhibiting property enabling the entire component (A) not to dissolve in alkaline before exposure, and which is dissociated from the unit (a2) by the action of acid generated from the component (B) to enable the entire component (A) to be alkali-soluble after exposure, can be used as an acid-dissociative dissolution controlling group in the unit (a2), without any limitations. Generally, the carboxyl group of the (meth)acrylic acid, forming the cyclic or chain tertiary alkyl ester, tertiary alkoxycarbonyl group, or chain alkoxyalkyl group is widely known.

The acid dissociable, dissolution inhibiting group is preferably a group forming a cyclic or chain tertiary alkyl ester, or a cyclic acetal group, more preferably a polycyclic aliphatic hydrocarbon group. As long as the polycyclic aliphatic hydrocarbon group forms a tertiary alkyl ester, there are no limitations; however polycyclic aliphatic hydrocarbon groups, in which a hydrogen atom is removed from a cycloalkane, bicycloalkane, tricycloalkane, tetracycloalkane, etc., which may be substituted or unsubstituted with a fluorine atom or a fluorinated alkyl group, are exemplified. Specific examples of the polycyclic aliphatic hydrocarbon groups include cycloalkanes such as cyclohexane; and polycycloalkanes, such as adamantane, norbornane, isobornane, tricyclodecane and tetracyclododecane; from which a single hydrogen atom has been removed. This type of polycyclic group may be selected from many groups for an ArF resist. Among these groups, adamanthyl, norbolnyl, and tetracyclododecanyl groups are preferable for industrial use, more preferably an adamanthyl group. Monomer units represented by the general formulas (4) to (12) below are preferred as the unit (a2).

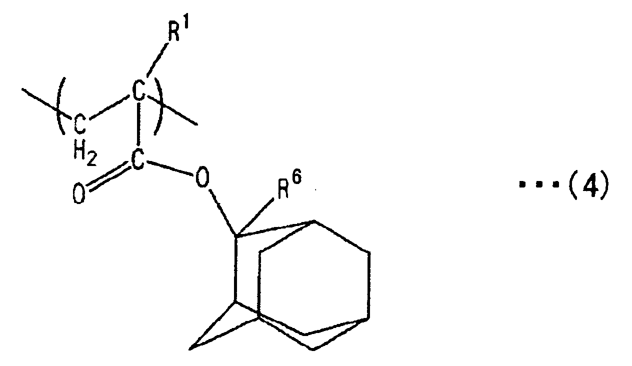

In the formula, R¹ represents a hydrogen atom or a methyl group, and R⁶ represents a lower alkyl group.

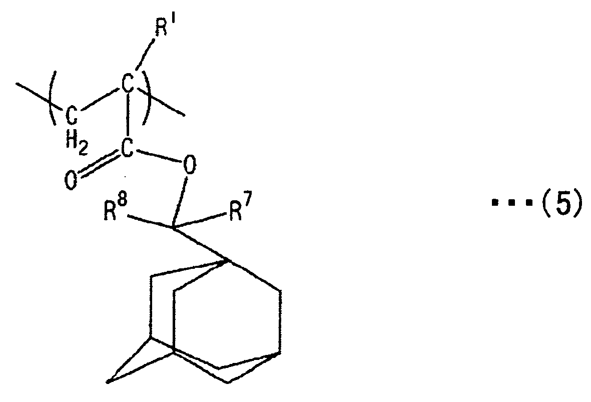

In the formula, R¹ represents a hydrogen atom or methyl group, and R⁷ and R⁸ independently represent lower alkyl groups.

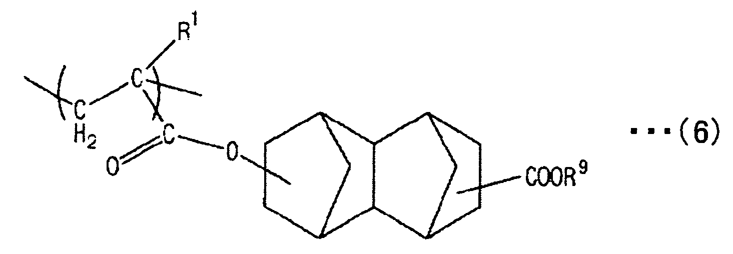

In the formula, R¹ represents a hydrogen atom or a methyl group, and R⁹ represents a tertiary alkyl group.

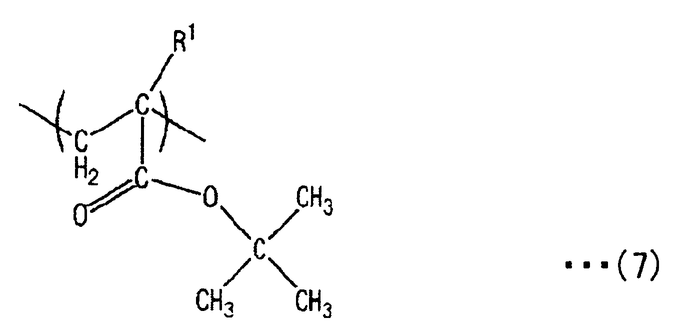

In the formula, R¹ represents a hydrogen atom or a methyl group.

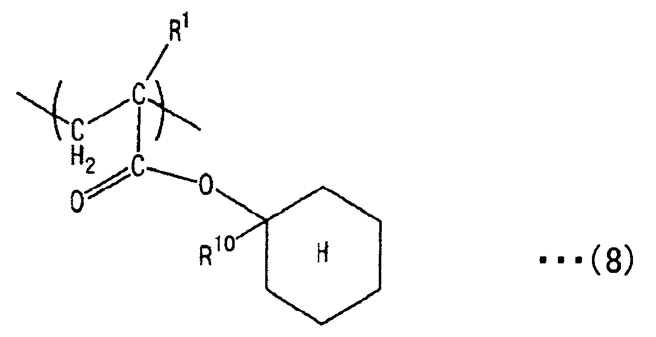

In the formula, R¹ represents a hydrogen atom or a methyl group, and R¹⁰ represents a methyl group.

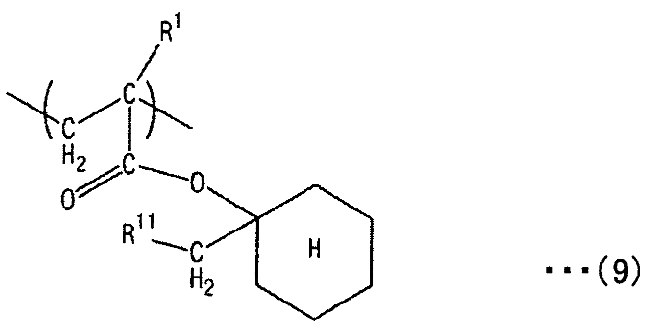

In the formula, R¹ represents a hydrogen atom or a methyl group, and R¹¹ represents a lower alkyl group.

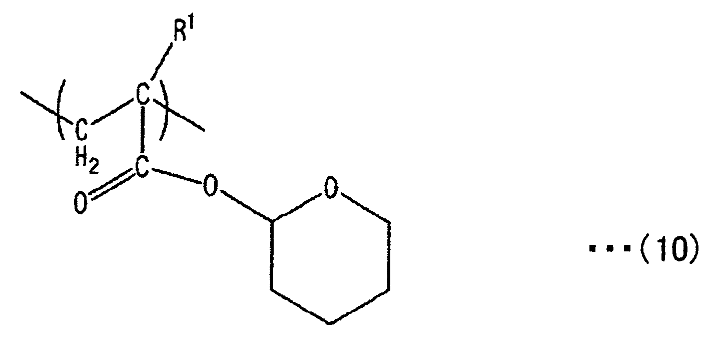

In the formula, R¹ represents a hydrogen atom or a methyl group.

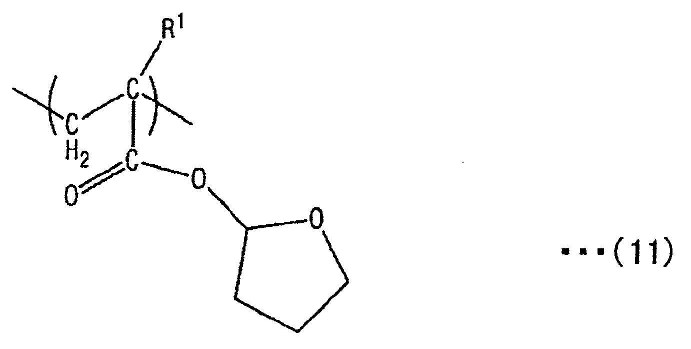

In the formula, R¹ represents a hydrogen atom or a methyl group.

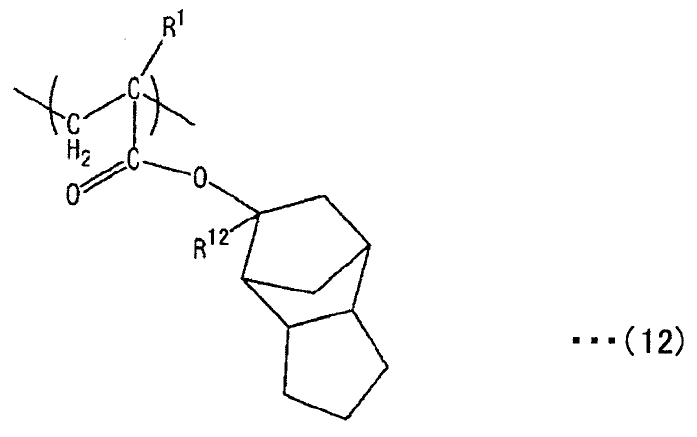

In the formula, R¹ represents a hydrogen atom or a methyl group, and R¹² represents a lower alkyl group.

Each of R⁶ to R⁸, and R¹¹ to R¹² is preferably a linear or branched lower alkyl group having 1 to 5 carbon atoms, and examples thereof include a methyl group, an ethyl group, a propyl group, an isopropyl group, an n-butyl group, an isobutyl group, a tert-butyl group, a pentyl group, an isopentyl group, and a neopentyl group. The methyl group or the ethyl group is preferable for industrial use.
R⁹ is a tertiary alkyl group such as a tert-butyl group or a tert-amyl group and a tert-butyl group is preferable for industrial use. Among the abovementioned constitutional units, the unit (a2) expressed by the general formulas (4), (5), and (6) are more preferable, and the unit expressed by the general formula (4) is most preferable, because these preferred units have a superior dissolution resistance to the solvent (immersion liquid) applied in a (liquid) immersion lithography process to form a pattern exhibiting a higher resolving ability.

In the units (a1) to (a6), which are constitutional units introduced from (meth)acrylic ester in the component (A) of the positive-type resist composition according to the present invention, the constitutional units introduced from both of methacrylic ester and acrylic ester are preferably included, so that the positive-type resist composition, which surface roughness and line edge roughness during etching are decreased, and having a superior resolving ability and increased depth of focus, can be obtained. This surface roughness does not mean the surface roughness caused by the effect of solvent, which deteriorates profile formation, and dry etching resistance, which is conventionally known. After the resist film is developed to form a resist pattern, the distortion appears around the contact hole of resist pattern etched, and line edge roughness appears in a line-and-space pattern. This line edge roughness occurs in a resist pattern after development. The line edge roughness appears, for example, as skewness around holes in a hole resist pattern, and as being uneven and convexo-concave on the side surfaces in the line-and-space pattern.

Nowadays, in the most advanced area in immersion lithography, resolving ability in the vicinity of 90nm, 65nm, 45, or less continues to be desired. Furthermore, an increased depth of focus characteristic is desired. In the component (A), the constitutional units induced from methacrylic ester and acrylic ester coexist; therefore, the resolving ability and the focal depth range can improve. In addition, by including these two constitutional units, the resist composition exhibits defect reducing effect. The term "defect" in general means flaws in the resist pattern and scum, which are detected on a resist pattern when the resist pattern is observed from directly above by a surface defect detection analysis device (KLA, by KLA Tencor) after development.

In this case, as long as the component (A) includes the constitutional unit induced from methacrylic ester and the constitutional unit induced from acrylic ester, there are no special limitations. For example, the component (A) may include the copolymer (A1), and a copolymer containing a constitutional unit induced from methacrylic ester and a constitutional unit induced acrylic ester. The component (A) may also include the resin mixture (A2), and a resin mixture containing a constitutional unit induced from at least methacrylic ester and a constitutional unit induced from at least acrylic ester. In addition, either of both polymers composing the resin mixture (A2) may be equivalent to the copolymer (A1). Furthermore, the component (A) can include other resin components; preferably, either or both of the copolymer (A1), the mixture resin (A2). The copolymer (A1) can respectively be used in combinations of two or more kinds of constitutional units, and the mixture resin (A2) can respectively be used in combinations of two or more kinds of polymers.

In component (A), the constitutional unit induced from methacrylic ester is 10 to 85 mol%, preferably 20 to 80 mol%, and the constitutional unit induced from acrylic ester is 15 to 90 mol%, preferably 20 to 80 mol% relative to the total amount of these constitutional units.

In cases in which the constitutional unit induced from methacrylic ester is greater than the upper limit, the effect of improving surface roughness is decreased. In cases in which the constitutional unit induced from acrylic ester is greater than the upper limit, the resolving ability may be deteriorated.

### Unit (a4)

When the unit (a3) in the component (A) in the positive-type resist composition according to the present invention is the constitutional unit (a4), induced from a (meth)acrylic ester that has a monocyclic or polycyclic group containing lactone, adhesion of a resist film and a substrate, and the hydrophilicity to the developer solution are enhanced due to the lactone. In addition, the dissolution resistance is superior to the solvent (immersion liquid) used in an immersion lithography process.

Any of the units, which have the lactone unit, and may copolymerize with any other unit of the component (A), may be used for the unit (a4). For example, the monocyclic lactone unit includes a γ-butyrolactone group, from which one hydrogen atom has been removed. The polycyclic lactone unit includes a polycyclic alkane group containing lactone, from which one hydrogen atom has been removed. In the lactone unit, a ring including the -O-C(O)- structure is counted as a first ring. Thus, the cyclic group that only includes a ring with the -O-C(O)- structure is referred to as a monocyclic group, and one that further includes other ring structures is referred as a polycyclic group despite the structure. Monomer units suitable for the unit (a4) are shown in the following general formulas (13) to (15).

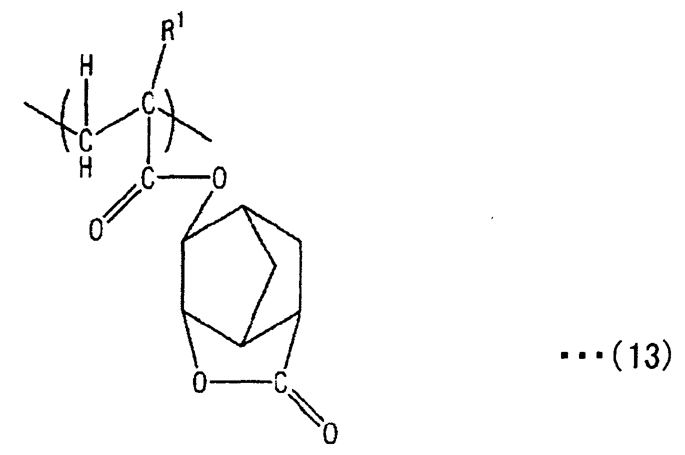

In the formula, R¹ represents a hydrogen atom or a methyl group.

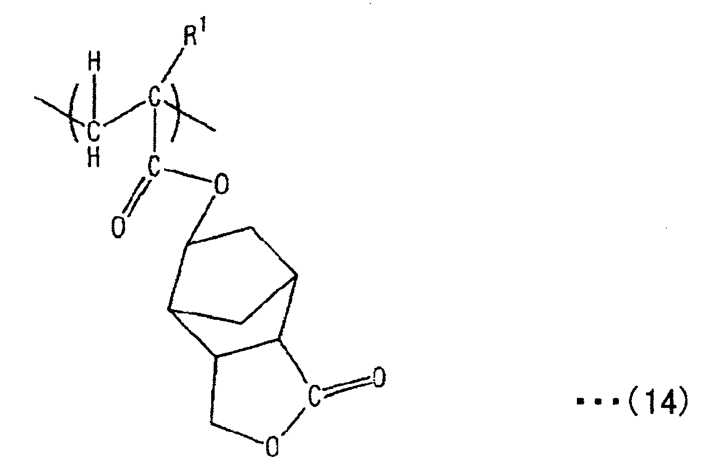

In the formula, R¹ represents a hydrogen atom or a methyl group.

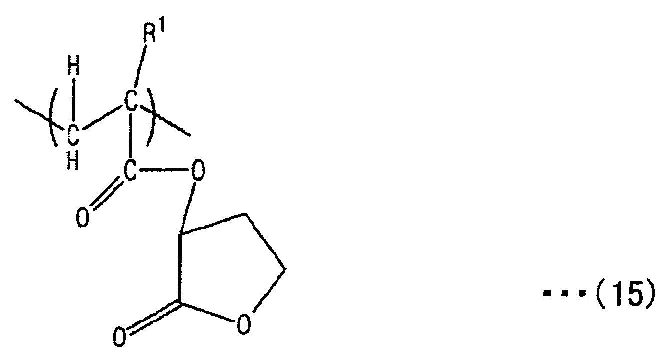

In the formula, R¹ represents a hydrogen atom or a methyl group.

The norbornane lactone ester in the general formulas (13) and (14), in particular, are preferable for practical use; and γ-butyrolactone ester of (meth)acrylic acid, in which an ester bond is formed to an α-carbon, as shown in the general formula (15), is more preferable.

### Unit (a5)

In the positive-type resist composition according to the present invention, the unit (a3) in the component (A) is the unit (a5), which is a constitutional unit derived from (meth)acrylic ester having a polycyclic group containing an alcoholic hydroxyl group. The hydroxyl group in the alcoholic hydroxyl group-containing polycyclic group is a polar group, and therefore the use of the unit (a5) increases the collective hydrophilicity of the component (A), with a developer solution to improve alkali-solubility in the exposed portion. Accordingly, it is preferable that the component (A) has the unit (a5), which improves the resolving ability.

The polycyclic group in (a5) may be properly selected from the same aliphatic polycyclic groups as those described above with reference to (a2). Any group may be used without any special limitation for the polycyclic group containing the alcoholic hydroxyl group in the unit (a5). For example, the adamanthyl group containing the hydroxyl group or the like may be preferably used. The adamanthyl group containing the hydroxyl group expressed by the general formula (16), which improves dry etching resistance, and enhances the verticality of the pattern cross section, is preferred.

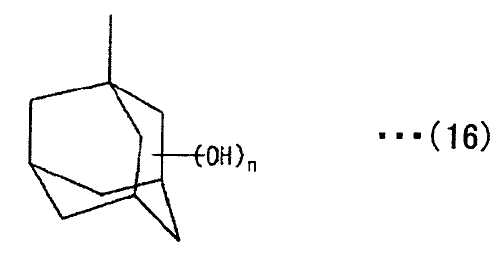

In the formula, n represents an integer from 1 to 3.

Any unit, which has the abovementioned polycyclic group containing the alcoholic hydroxyl group, and which may be copolymerized with any other constitutional unit of the component (A), may be used for the unit (a5). Specifically, the structural unit as represented by the following general formula (17) is particularly preferred.

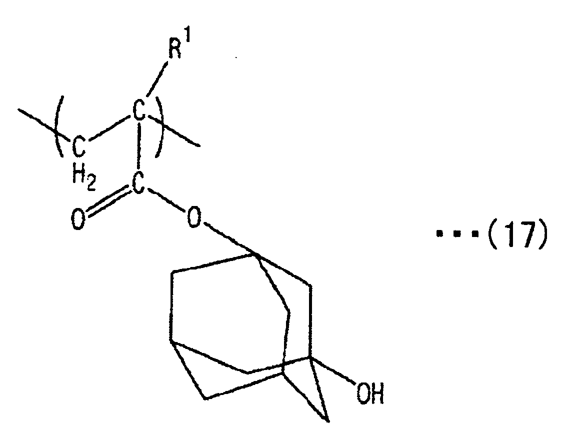

In the formula, R¹ represents a hydrogen atom or a methyl group.

### Unit (a6)

In the positive-type composition according to the present invention, when the unit (a3) in the component (A) is the unit (a6), the previously mentioned, "The polycyclic group is different from the abovementioned acid-dissociative inhibiting group, the abovementioned lactone unit, and the polycyclic group containing alcoholic hydroxyl group" means that in the composition (A), the polycyclic group of the unit (a6) is different from the organic group of the unit (a1), the acid-dissociative inhibiting group of the unit (a2), the lactone unit of the unit (a4), or the polycyclic group containing alcoholic hydroxyl group of the unit (a5). In other words, the unit (a6) does not contain the organic group of the unit (a1), the acid-dissociative inhibiting group of the unit (a2), the lactone unit of the unit (a4), and the polycyclic group containing alcoholic hydroxyl group of the unit (a5), all of which compose the component (A).

The polycyclic group in the unit (a6) may be different from the constitutional units used as the units (a1) to (a5) in one of components (A); however there are no limitations in particular. For example, the same aliphatic polycyclic group as the unit exemplified as the unit (a2) may be used for the polycyclic group of the unit (a6); therefore, many conventionally known constitutional units as ArF positive resist materials, may be selected. In particular, at least one or more groups selected from a tricyclodecanyl group, an adamanthyl group, and a tetracyclododecanyl group is preferably selected for industrial availability.

Any unit may be used for the unit (a6) provided that the unit has the abovementioned polycyclic group and can be copolymerized with any other constitutional unit of the component (A). The preferred example is shown in the chemical formulas (18) to (20) below.

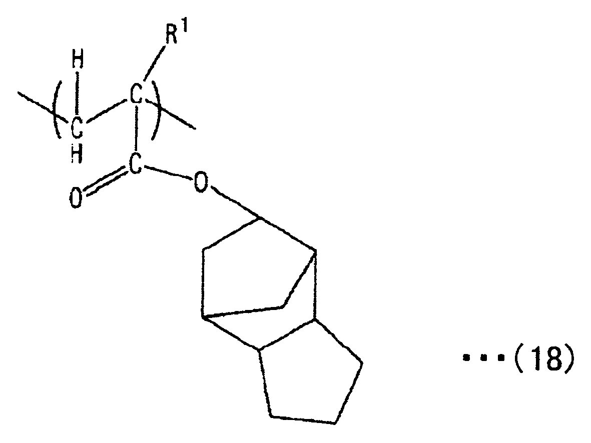

In the formula, R¹ represents a hydrogen atom or a methyl group.

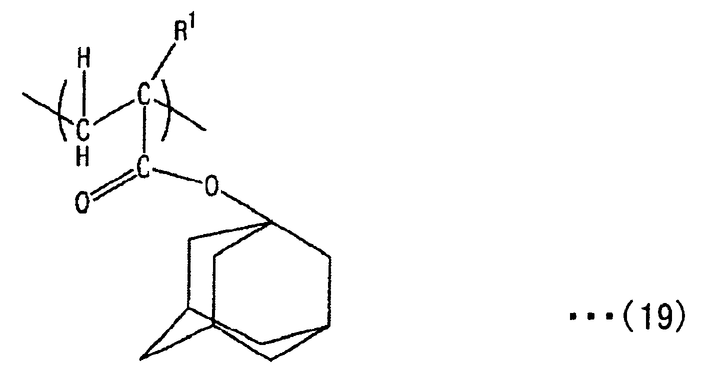

In the formula, R¹ represents a hydrogen atom or a methyl group.

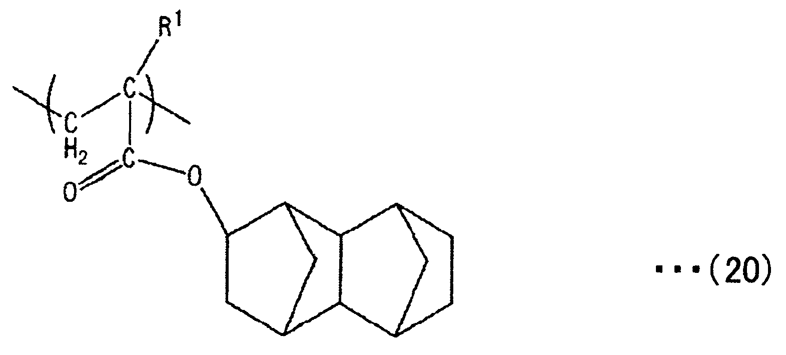

In the formula, R¹ represents a hydrogen atom or a methyl group.

### Unit (a7)

In the positive-type composition according to the present invention, when the unit (a3) in the component (A) is the unit (a7), the constitutional unit expressed by the general formula (3) below is preferable.

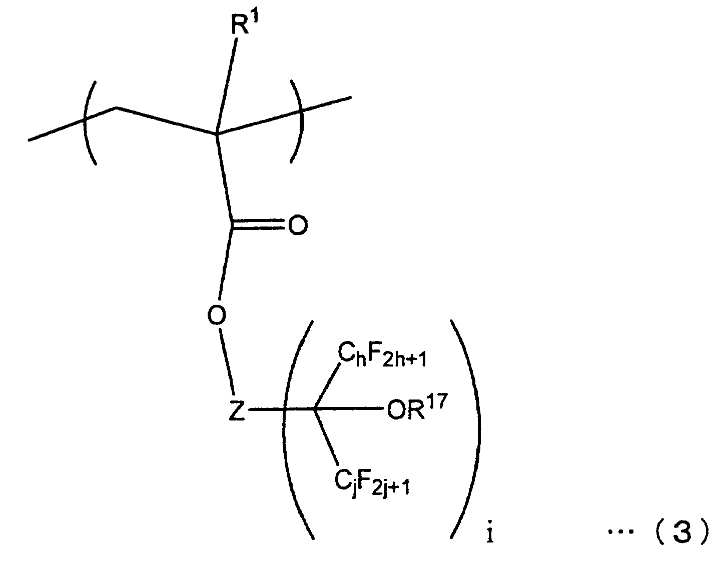

In the formula (3), Z represents a divalent or trivalent cyclic group. R¹ represents a hydrogen atom or a methyl group. R¹⁷ represents a hydrogen atom, a chain, a branched or a cyclic alkyloxymethyl group having 1 to 15 carbons. h and j respectively, are integers from 1 to 5, and i is an integer of 1 or 2.

In the general formula (3), R¹ is preferably a methyl group. R¹⁷ is preferably a hydrogen atom, a chain, a branched or a cyclic alkyloxymethyl group having 1 to 5 carbons. h and j respectively, are preferably integers from 1 to 3, most preferably 1. i is preferably 2.

In the unit (a7), the cyclic group is a divalent or trivalent organic group, which binds an oxygen atom of (meth)acrylic ester in the unit (a7), and has one or two fluorinated organic groups in its ring. In the general formula (3), a divalent or trivalent cyclic group expressed by Z includes an aliphatic or aromatic cyclic group without any limitations in particular. Among these, an aromatic cyclic group may be used in the photoresist composition for KrF exposure. To improve transparency, an aliphatic ring formula is preferably used, in particular, in the photoresist composition for ArF exposure.

For the aromatic cyclic group, various monocyclic or polycyclic divalent or trivalent aromatic cyclic groups may be used without any limitations in particular. Examples of aliphatic cyclic hydrocarbons, which may be used as this kind of aromatic cyclic group, include benzene, naphthalene, anthracene and the like.

For the aliphatic cyclic group, various monocyclic or polycyclic divalent or trivalent aliphatic cyclic groups may be used without any limitations in particular. Examples of aliphatic cyclic hydrocarbons, which may be used as this kind of aliphatic cyclic group, include monocyclic aliphatic cyclic groups such as cyclohexane, cyclopentane, and the polycyclic aliphatic cyclic hydrocarbon exemplified in the unit (a1). An aliphatic cyclic group is used by removing 1 to 3 hydrogen atoms from this carbon hydride. Among these, the monocyclic aliphatic hydrocarbon group is preferably a group in which 2 to 3 hydrogen atoms are removed from cyclohexane or cyclopentane, most preferably from cyclohexane.

The fluoro organic group of the unit (a7) is formed by at least partially substituting hydrogen atoms of the organic group with fluorine atoms, and has a substituted or unsubstituted alcoholic hydroxyl group. In addition, one or more fluorinated organic groups bind to the cyclic group. Introducing a substituted or unsubstituted fluorinated alcohol in an organic group improves the transparency of the photoresist composition.

As the general formula (3) shows, the fluorinated organic group is preferably an alcoholic hydroxyl group in which a carbon atom adjacent to a carbon atom of a branched chain binds to a substituted or unsubstituted alcoholic hydroxyl group. In this case, the number of carbon atoms in the branched chain is from 1 to 5, preferably from 1 to 3, and more preferably 2.

In the unit (a7), the alcoholic hydroxyl group, which the fluorinated organic group has, may be unsubstituted alcohol, or an alcohol substituted by a protective group. This protective group acts as an acid dissociable, dissolution inhibiting group increasing the alkali-solubility of the resin component (A) by acid action. The unit (a7) has this acid dissociable, dissolution inhibiting group, so that the resist composition exhibits dissolution suppression function to alkali development before exposure and alkaline-solubility by deprotection after exposure or PEB process. Therefore, the alkaline-solubility is widely varied before and after exposure, so that the film loss of the resist pattern formed is prevented to obtain a micro pattern which has superior resolving ability.

The protective group, in which R² is not a hydrogen atom in the general formula (3), is preferable a chain, a branched or a cyclic alkyloxymethyl group with 1 to 15 carbon atoms. In terms of acid dissociation performance, in particular, it is preferably a lower alkoxymethyl group, such as a methoxymethyl group, because of its higher resolving ability and superior pattern configuration. The rate of the acid dissociable, dissolution inhibiting group is 10 to 40%, preferably 15 to 30% based on the alcoholic hydroxyl groups from the viewpoint of excellent pattern-forming ability.

In the positive-type resist composition according to the present invention, the unit (a1) is preferably 5 to 65 mol%, more preferably 10 to 60 mol% relative to the total constitutional units of the component (A), in order that a superior resolving ability may be achieved. The unit (a2) is preferably 20 to 60 mol%, more preferably 30 to 50 mol% relative to the total constitutional units of the component (A), in order that a superior resolving ability may be achieved. The unit (a4) is preferably 5 to 60 mol%, more preferably 20 to 50 mol% relative to the total constitutional units of the component (A), in order that superior resolving ability and adhesion may be achieved. Moreover, the unit (a5), if being used, is preferably 5 to 50 mol%, more preferably 10 to 40 mol% relative to the total constitutional units of the component (A) in order that a superior resist pattern configuration may be achieved. Furthermore, the unit (a6), if being used, is preferably 1 to 30 mol%, more preferably 5 to 20 mol% relative to the total constitutional units of the component (A), in order that a superior higher resolving ability from an isolated pattern into semi-dense pattern may be achieved. Moreover, the unit (a7), if being used, is preferably 5 to 65 mol%, more preferably 10 to 60 mol% relative to the total constitutional units of the component (A), in order that superior resolving ability may be achieved.

In the immersion exposure (lithography) process, a binary copolymer, in which the constitutional unit (a1) is 5 to 65 mol%, preferably 10 to 60 mol%; and the constitutional unit (a2) is 20 to 60 mol%, preferably 25 to 55 mol%, and a tertiary copolymer, in which the constitutional unit (a1) is 10 to 50 mol%, preferably 10 to 40 %; the constitutional unit (a2) is 20 to 60 mol%, preferably 25 to 55 %; and the constitutional unit (a3) is 10 to 50 mol%, preferably 15 to 45 %, are preferred, so that the positive-type resist composition using these copolymers can form a resist pattern with superior sensitivity and profile configuration. Among these, the unit (a3) is most preferably the unit (a4) or (a7).

The component (A) in the positive-type resist composition according to the present invention is easily produced by copolymerizing monomers respectively consisting of the unit (a1) and (a2), and optionally (a4), (a5), (a6), and/or (a7) by radical polymerization, or the like, using a radical polymerization initiator like azobisisoblutyronitrile (AIBN).

The resin component (A) according to the present invention is the mass average molecular weight of 5,000 to 30,000, and more preferably 8,000 to 20,000 without any limitation. The mass average molecular weight, which is expressed hereafter based on the polystyrene standards. A value larger than this range may deteriorate the dissolution of the resin component into the resist solvent, while a smaller value may adversely affect resistance to dry etching and the cross sectional configuration of resist patterns.

### Acid Generator Component (B)

The acid generator (B) in the positive-type resist composition according to the present invention may be selected from a group of well known acid generators for a conventional chemically amplified resist, and used.

Among these acid generators, an onium salt, in which a fluorinated alkylsulfonic acid ion is included as an anion, is preferred. Examples of preferred acid generators include diphenyliodonium trifluoromethanesulfonate, (4-methoxyphenyl)phenyliodonium trifluoromethanesulfonate, bis(p-tert-butylphenyl)iodonium trifluoromethanesulfonate, triphenylsulfonium trifluoromethanesulfonate, (4-methoxyphenyl)diphenylsulfonium trifluoromethanesulfonate, (4-methoxyphenyl)diphenylsulfonium nonafluorobutanesulfonate, (4-methoxyphenyl)diphenylsulfonium heptafluoropropanesulfonate, (4-methylphenyl)diphenylsulfonium nonafluorobutanesulfonate, (4-methylphenyl)diphenylsulfonium trifluoromethanesulfonate, (4-methylphenyl)diphenylsulfonium heptafluoropropanesulfonate, (p-tert-butylphenyl)diphenylsulfonium trifluoromethanesulfonate, diphenyliodonium nonafluorobutanesulfonate, bis(p-tert-butylphenyl)iodonium nonafluorobutanesulfonate, triphenylsulfonium heptafluoropropanesulfonate, triphenylsulfonium nonafluorobutanesulfonate, triphenylsulfonium perfluorooctanesulfonate, (4-trifluoromethylphenyl)diphenylsulfonium trifluoromethanesulfonate, (4-trifluoromethylphenyl)diphenylsulfonium nonafluorobutanesulfonate, (4-trifluoromethylphenyl)diphenylsulfonium heptafluoropropanesulfonate, tri(p-tert-butylphenyl)sulfonium trifluoromethanesulfonate, tri(p-tert-butylphenyl)sulfonium nonafluorobutanesulfonate, tri(p-tert- butylphenyl)sulfonium heptafluoropropanesulfonate, and the like. Among these, a sulfonium salt is preferred, onium salt which includes a fluorinated alkylsulfonic acid ion as an anion is more preferred, and onium salt which includes a fluorinated alkylsulfonic acid ion with 3 to 8 carbons as an anion, is particularly preferred.

The component (B) may be used alone or in combinations of two or more acid generators. The amount of the component (B) used is 0.5 to 30 parts by mass, and preferably 1 to 10 parts by mass to 100 parts by mass of the resin component (A). At less than 0.5 parts by mass, patterning is not satisfactorily performed, while at more than 30 parts by mass, a homogeneous solution is difficult to prepare, which may deteriorate stability under storage conditions.

### Organic Solvent (C)

The positive-type resist composition according to the present invention can be produced by dissolving the resin component or the component (A), the component (B), and optionally the component (D) and/or the component (E) described below in the organic solvent (C). The organic solvent (C), which enables the resin component or the components (A) and (B) to be dissolved homogeneously, may be used. One, or two or more kinds of solvents may be appropriately used by being selected from known solvents for chemically amplified resists.

Specific examples of the organic solvent (C) include ketones such as γ-butyrolactone, acetone, methylethylketone, cyclohexanone, methylisoamylketone and 2-heptanone; polyalcohols and derivatives thereof, such as ethylene glycol, ethylene glycol monoacetate, diethylene glycol, diethylene glycol monoacetate, propylene glycol, propylene glycol monoacetate and dipropylene glycol, monomethylether, monoethylether, monopropylether monobutylether and monophenylether; cyclic ethers such as dioxane; and esters such as methyl lactate, ethyl lactate, methyl acetate, ethyl acetate, butyl acetate, methyl pyruvate, ethyl pyruvate, methyl methoxy propionate, and ethyl ethoxy propionate. These organic solvents may be used alone or in combinations of two or more.

Among these, the mixed solvent with a polar solvent having a hydroxy group or a lactone, such as propylene glycol monomethyl ether acetate (PGMEA), propylene glycolmonomethyl ether (PGME), ethyl lactate (EL), and γ-butyrolactone, enhances the preservation stability of the positive-type resist composition. When EL is mixed with PGMEA, the mass ratio of PGMEA:EL is preferably from 9:1 to 1:9, more preferably from 8:2 to 2:8. When PGME is mixed with PGMEA, the mass ratio of PGMEA:PGME is preferably from 8:2 to 2:8, more preferably from 8:2 to 5:5.

In the positive-type resist composition according to the present invention, the solid content of the resist composition is 3 to 30 mass%, preferably 5 to 20 mass%, and the amount of the organic solvent (C) is set depending on the thickness of the resist film.

### Other Component

In order to improve the resist pattern configuration, and enhance the post exposure stability, a nitrogen-containing organic compound (D) (hereinafter referred to as "component (D)") may be additionally incorporated into the positive-type resist composition according to the present invention as an optional component. The component (D) may be selected from various compounds proposed in the art, preferably secondary aliphatic amines or tertiary aliphatic amines. The aliphatic amine includes the amine of alkyl or alkyl alcohol with 15 or less carbon atoms, and examples of secondary amines and tertiary amines include trimethylamine, diethylamine, triethylamine, tributylamine, di-n-propylamine, tri-n-propylamine, tripentylamine, tridodecylamine, trioctylamine, diethanolamine, and triethanolamine, and in particular, alkanolamines such as triethanolamine are preferably used. In addition, the nitrogen-containing organic compound is expressed by the general formula (21) below.

N (̵R¹³-O- R¹⁴-O- R¹⁵)₃ (21)

In the formula, R¹³ and R¹⁴ each represent independently a lower alkylene group and R¹⁵ represents a lower alkyl group.

In the general formula (21), R¹³, R¹⁴, and R¹⁵ may be a normal chain, a branched chain or a cyclic group; however, a normal chain or a branched chain group are preferred. From the viewpoint of molecular weight adjustment, the number of carbons in R¹³, R¹⁴, and R¹⁵ is preferably from 1 to 5 respectively, more preferably from 1 to 3. The number of carbons in R¹³, R¹⁴, and R¹⁵ may be the same or different from each other. The structure of R¹³ and R¹⁴ may be the same or different from each other.

Examples of the compounds expressed by the general formula (21) includes tris-(2-methoxymethoxyethyl)amine, tris-2-(2-methoxy(ethoxy))ethylamine, tris-(2-(2-methoxyethoxy)methoxyethyl)amine, and the like. Among these, tris-2-(2-methoxy(ethoxy))ethylamine is preferred. Of these nitrogen-containing organic compounds, the compound expressed by the general formula (21) is preferred, and in particular, tris-2-(2-methoxy(ethoxy))ethylamine, which has a reduced solubility in the solvent used in an immersion lithography process, is more preferred. These may be used alone or in combinations of two or more. These amines are used in an amount of 0.01 to 5.0 parts by mass to 100 parts by mass of the resin component or the component (A).

In order to prevent degradation in sensitivity due to the component (D), to improve resist patterns configuration, and to enhance post exposure stability, an organic carboxylic acid or phosphorous oxo acid or derivative thereof (E) (hereinafter referred to as "component (E)") may be additionally incorporated as an optional component. Furthermore components (D) and (E) may be utilized alone or in combination. Preferable examples of the organic carboxylic acids include malonic acid, citric acid, malic acid, succinic acid, benzoic acid, and salicylic acid. The phosphorous oxo acid or derivative thereof may be phosphoric acid and its ester derivatives, such as phosphoric acid, di-n-butyl phosphate, and diphenyl phosphate; phosphonic acid and its ester derivatives, such as phosphonic acid, dimethyl phosphate, din-butyl phosphonate, phenyl phosphonic acid, diphenyl phosphonate and dibenzyl phosphonate; and phosphinic acid and its ester derivatives, such as phosphinic acid and phenylphosphinic acid. Among these, phosphoric acid is preferred. The component (E) is utilized at a proportion of 0.01 to 5.0 parts by mass to 100 parts by mass of component (A).

The positive type resist composition according to the present invention may further contain miscible additives if desired, additional resins to improve the performance of resist film, surfactants to enhance coat ability, anti-dissolving agents, plasticizers, stabilizers, coloring agents, and anti-halation agents.

For producing the positive-resist composition according to the present invention, the components described later are mixed and stirred by way of the general method, and may be dispersed by a dispersion device, such as a dissolver, homogenizer, or three roll mill, and then mixed. After mixing, the mixture may be filtered by using a mesh, a membrane filter, or the like. Method for Forming Pattern

The method for forming a resist pattern according to the present invention is described below. First, the resist composition according to the present invention is applied on a substrate such as a silicon wafer with a spinner or the like, and then the substrate is pre-baked (PAB process). Alternatively, a two-layer laminated body with an organic or inorganic anti-reflection film laid between the substrate and the coated layer of the resist composition may also be used. The two-layer laminated body with an organic anti-reflection film laid on the coated layer of the resist composition may also be used. In addition, a three-layer laminated body with an organic anti-reflection film laid on the lower layer of the resist composition may be used. Up to this process everything may be performed by a known method. The operating conditions are preferably set depending on the constitution and characteristics of the resist composition.

Second, through the desired mask pattern, liquid immersion lithography is optionally conducted for the obtained resist layer, which is a coated film of the resist layer. The exposure is preferably conducted in a state, in which an immersion liquid that has a larger refractive index than that of air is previously filled between the resist layer and the lens placed at the lowest position on the lithography device. Any wavelength of the exposing light beam may be used with no limitations, and any radiation ray may be used including an ArF excimer laser, KrF excimer laser, F₂ excimer laser, EUV (Extreme Ultra Violet), VUV (Vacuum Ultra Violet), electron beam, X-ray, and soft X-ray. The resist compositions according to the present invention may be effectively employed together with a KrF or an ArF excimer laser, in particular an ArF excimer laser.

In the method for forming the pattern according to the present invention, a solvent that has a larger refractive index than that of air is preferably filled between the resist layer and the lens, placed at the lowest position on the lithography device.

Examples of solvents that have a larger refractive index than that of air include water and fluorocarbon inert liquids. Specific examples of the fluorocarbon inert liquids include liquids in which the main component is fluorocarbon compounds, such as C₃HCl₂F₅, C₄F₉OCH₃, C₄F₉OC₂H₅, or C₅H₃F₇, or perfluorocarbon compounds in which the boiling point is 70 to 180 degrees C, preferably 80 to 160 degrees C. Actual examples of this type of perfluoroalkyl compound include perfluoroalkylether compounds and perfluoroalkylamine compounds. An actual example of the perfluoroalkylether compound includes perfluoro(2-butyl-tetrahydrofuran), of which the boiling point is 102 degrees C, and examples of the perfluoroalkylamine compound include perfluorotributylamine (boiling point of 174 degrees C). Fluorocarbon inert liquid having the abovementioned range in boiling point can easily remove the immersion liquid after exposure is complete, to be preferably used. The resist composition according to the present invention is less adversely affected, in particular by water, and exhibits superior sensitivity and a superior resist pattern profile configuration. In addition, water is preferably used from the viewpoint of cost, safety, environmental issues, and general purpose properties. Any refractive index higher than that of air may be used as long as it is in the abovementioned range.

After the exposure process finishes, and PEB (post-exposure baking) process is finished, then the resist film is developed by using an alkali developer composed form an alkali aqueous solution. Preferably, the resist film is rinsed using de-ionized water. In water rinse step, for example, water is dripped or sprayed onto the substrate while the substrate is being turned to wash away the developing solution and the residue resist composition dissolved by the developing solution on the substrate. Then, the coating film of the resist composition is dried to obtain a resist pattern exactly the same as that of a mask pattern. By forming the resist pattern in this way, a resist pattern with fine line widths, and in particular, a line-and-space (L&S) pattern having a small pitch may be formed at a superior resolving ability. Herein, a pitch in the line-and-space-pattern is the total distance of the resist pattern width and the space width in the direction of the line width of pattern.

### Examples

The present invention is described in detail based on the Examples below. It should be noted that the present invention is not limited to the following examples.

In the following Examples and Comparative Examples, unless otherwise specified, conditions for the simulated immersion lithography and sensitivity measurement are as follows.
(1) Conditions for forming a resist coating film
   Substrate: 8-Inch silicon wafer
   Method for resist application: Using a spinner onto a substrate while rotating the substrate at 2000 rpm
   Size of resist coating film: Coating film having a diameter of 6 inches and a thickness 150 or 250 nm, being arranged in concentric circle on the substrate.
   Prebake condition: At 90 degrees C for 90 seconds in Example 1; at 110 degrees C for 90 seconds in Example 2; 90 degrees C for 90 seconds in Example 3; and at 95 degrees C for 90 seconds in Comparative Example 1.
   Selective exposure conditions: Using an ArF excimer laser (193 nm) exposure system (NSR-S302B, by Nikon Corporation; NA (numerical aperture)=0.60, 2/3 annular illumination)
(2) Conditions for contact of resist coating film with solvent
   Number of revolutions of substrate: 500 rpm
   Solvent: water
   Solvent dropping rate: 1.0 L/minute
   Solvent dropping time: 2 minutes
   Temperature for contact of resist with solvent: 23 degrees C
(3) Conditions for forming a resist pattern
   Post-bake condition: at 90 degrees C for 90 seconds in Example 1; at 110 degrees C for 90 seconds in Example 2; 90 degrees C for 90 seconds in Example 3; and at 100 degrees C for 90 seconds in Comparative Example 1

Alkaline development conditions: Using 2.38 mass% of tetramethylammonium hydroxide water solution at 23 degrees C for 60 seconds.

In addition, in the Examples and Comparative Examples, a contact angle was measured by the contact angle master (CA-X150, by Kyowa InterFACE Science Co., LTD). The method for measuring a contact angle was as follows: 10 mass% of resin solution in the Examples and Comparative Examples, in which resin was dissolved in the mixture solvent of which the mass ratio is 6:4 of propylene glycol monomethyl ether acetate:ethyl lactate, was prepared; the resin solution was coated onto 6 inch silicon wafer to form a 150 nm thickness of a resist film by heating; and then the resist film was put in contact with an injector provided in the contact angle master, and then 2 µL of pure water was dripped onto the resist film to measure the contact angle every 0.1 seconds.

### Example 1

The component (A), the component (B), and the component (D) shown below were uniformly dissolved in the component (C) to prepare the positive resist composition 1. The component (A) used was 100 parts by mass of a methacrylate/acrylate copolymer composed of two constitutional units expressed by the following chemical formula (22). The ratio of the constitutional units o and p used for preparing the component (A) is o=51 mol% and p=49 mol%. The component (A) prepared had a mass average molecular weight of 9,800 and dispersion degree of 1.36. The contact angle with pure water was 81.2 degrees.

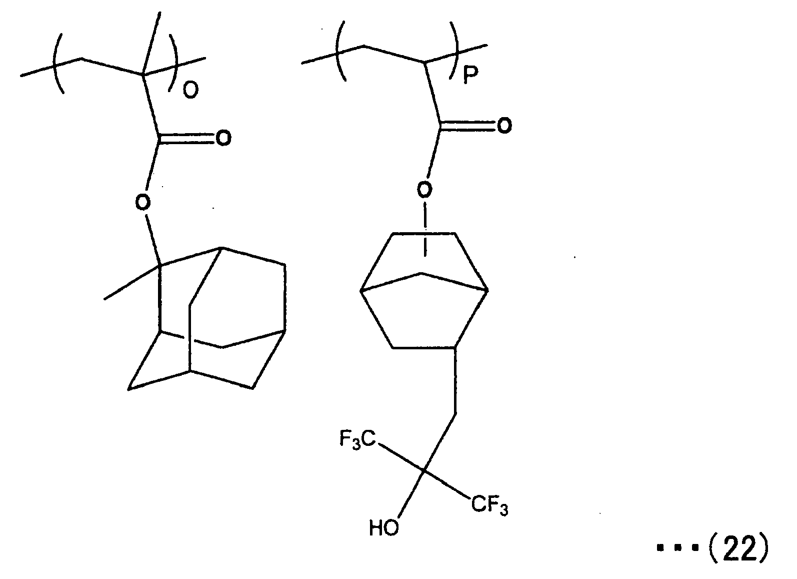

As the component (B), 5 parts by mass of triphenylsulfonium nonafluorobutanesulfonate was used. As the component (C), 1600 parts by mass of a mixed solvent of propylene glycol monomethyl ether acetate and ethyl lactate (mass ratio=6:4) was used. As component (D), 0.45 parts by mass of triethanolamine was used.

The obtained resist composition 1 was used to form a resist pattern. An organic anti-reflection coating composition "AR-19" (trade name, by Shipley) was first applied onto a silicon wafer using a spinner, and dried by calcinations on a hot plate at 215 degrees C for 60 seconds to form an organic anti-reflection coating film having a thickness of 82 nm. The obtained positive resist composition 1 was then applied onto the anti-reflection coating film using a spinner, and dried by prebake on a hot plate at 90 degrees C for 90 seconds to form a resist layer having a thickness of 150 nm on the anti-reflection coating film. Next, the resist layer was selectively irradiated through a mask pattern with an ArF excimer laser (193 nm) by means of an exposure system (NSR-S302B, by Nikon Corporation; NA (numerical aperture)=0.60, 2/3 annular illumination). In simulated immersion lithography treatment, when rotating the silicon wafer having the resist layer exposed, pure water was then allowed to drip onto the resist layer at 23 degrees C for 2 minutes. Subsequently, the resist layer was subjected to PEB treatment at 90 degrees C for 90 seconds, and subjected to development using an alkaline developer solution at 23 degrees C for 60 seconds. As the alkaline developer solution, a 2.38 mass% tetramethylammonium hydroxide water solution was used.

Thus the formed resist pattern having a 130 nm 1:1 line and space was examined under a scanning electron microscope (SEM), and its sensitivity (Eop) was determined. In the resist composition 1, Eop (X2) was 20.6 mJ/cm². The resist pattern was excellent, such that no T-top formation or surface roughness was observed. A resist pattern was formed with the resist composition 1 in the same manner except that a general exposure lithography process without the simulated immersion lithography process, and Eop (X1) was 20.4 mJ/cm². A ratio of the sensitivity in the simulated immersion lithography treatment to the sensitivity in the normal exposure [(X2/X1)-1]×100=[(20.6/20.4)-1]×100 was determined, and the result was 0.98.

### Example 2

The component (A), the component (B), and the component (D) shown below were uniformly dissolved in the component (C) to prepare positive resist composition 2. As the component (A), 100 parts by mass of a methacrylate/acrylate copolymer comprising three types of constitutional units represented by the chemical formula (23) below was used. The ratio of the constitutional units q, r, and s used for preparing the component (A) is q=46.7 mol%, r=39.9 mol% and s=13.4 mol%. The component (A) prepared had a mass average molecular weight of 9000 and a dispersion degree of 1.86. The contact angle with pure water was 80.2 degrees.

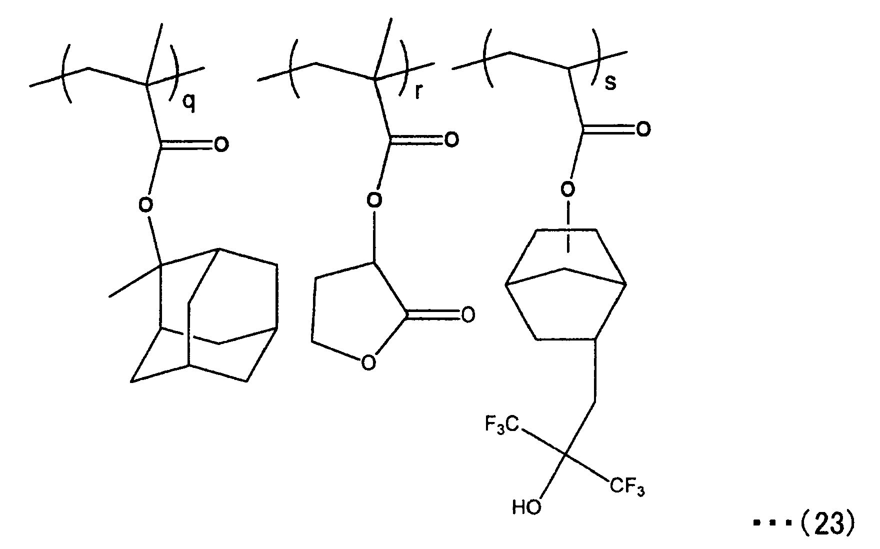

As component (B), 5 parts by mass of triphenylsulfonium nonafluorobutane sulfonate was used. As the component (C), 1,600 parts by mass of a mixed solvent of propylene glycol monomethyl ether acetate and ethyl lactate (mass ratio=6:4) was used. As component (D), 0.45 parts by mass of triethanolamine was used.

The obtained positive resist composition 2 was used to form a resist pattern. An organic anti-reflection coating composition "AR-19" (trade name, by Shipley) was first applied onto a silicon wafer using a spinner, and dried by calcinations on a hot plate at 215 degrees C for 60 seconds to form an organic anti-reflection coating film having a thickness of 82 nm. The obtained positive-type resist composition 1 was then applied onto the anti-reflection coating film using a spinner, and dried by prebake on a hot plate at 110 degrees C for 90 seconds to form a resist layer having a thickness of 150 nm on the anti-reflection coating film. Next, the resist layer was selectively irradiated through a mask pattern with an ArF excimer laser (193 nm) by means of an exposure system (NSR-S302B, by Nikon Corporation; NA (numerical aperture)=0.60, 2/3 annular illumination). In simulated immersion lithography treatment, when rotating the silicon wafer having the resist layer exposed, pure water was allowed to drip onto the resist layer at 23 degrees C for 2 minutes. Subsequently, the resist layer was subjected to PEB treatment at 110 degrees C for 90 seconds, and subjected to development using an alkaline developer solution at 23 degrees C for 60 seconds. As the alkaline developer solution, a 2.38 mass% tetramethylammonium hydroxide water solution was used.

Thus formed resist pattern having a 130 nm line and space of 1:1 was examined under a scanning electron microscope (SEM), and its sensitivity (Eop) was determined. In the resist composition 2, Eop (X2) was 16.5 mJ/cm². The resist pattern was excellent, such that no T-top formation or surface roughness was observed. A resist pattern was formed with the resist composition 2 in the same manner except that a general exposure lithography process without the simulated immersion lithography process, and Eop (X1) was 16.1 mJ/cm². The ratio of sensitivity in the simulated immersion lithography treatment to the sensitivity in the normal exposure [(X2/X1)-1]×100=[(16.5/16.1)-1]×100 was determined, and the result was 2.48.

### Comparative Example 1

The component (A), the component (B), and the component (D) shown below were uniformly dissolved in the component (C) to prepare the positive resist composition 3. As the component (A), 100 parts by mass of a polymer (FPR-120, by ASAHI GLASS CO., LTD) constituting of constitutional units represented by the chemical formula (24) below was used. The component (A) prepared had a mass average molecular weight of 40,000. The ratio of the methoxymethyl group incorporated to all the hydroxyl groups was 20%. The contact angle with pure water was 73.9 degrees.

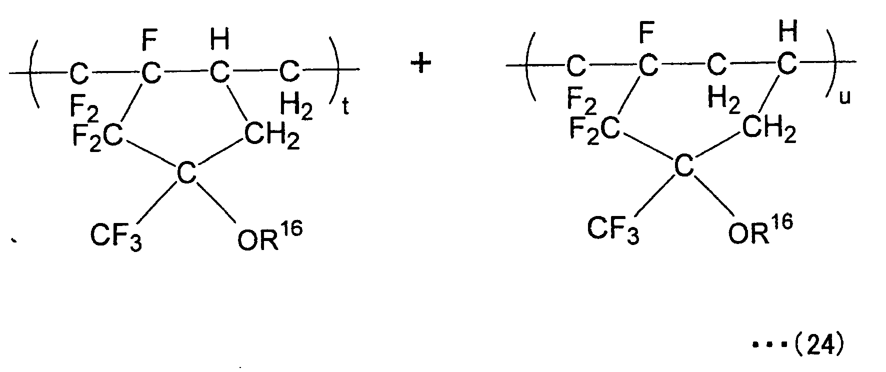

In the formula, R¹⁶ represents -CH₂OCH₃ or a hydrogen atom, and each of t and u is 50 mol%.

As the component (B), 2 parts by mass of triphenylsulfonium nonafluorobutanesulfonate was used. As the component (C), a mixed solvent of propylene glycol monomethyl ether acetate and ethyl lactate (mass ratio=6:4) was used to prepare the component having a 10 mass% in solid content. As the component (D), 0.3 part by mass of triisopropanolamine was used.

A resist pattern was formed by using the obtained positive resist composition 3. An organic anti-reflection coating composition "AR-19" (trade name, by Shipley) was first applied onto a silicon wafer using a spinner, and dried by calcinations on a hot plate at 215 degrees C for 60 seconds to form an organic anti-reflection coating film having a thickness of 82 nm. The obtained positive resist composition was then applied onto the anti-reflection coating film using a spinner, and dried by prebake on a hot plate at 95 degrees C for 90 seconds to form a resist layer having a thickness of 250 nm on the anti-reflection coating film. Next, the resist layer was selectively irradiated through a mask pattern with an ArF excimer laser (193 nm) by means of an exposure system (NSR-S302B, by Nikon Corporation; NA (numerical aperture)=0.60, 2/3 annular illumination). In a simulated immersion lithography treatment, when rotating the silicon wafer having the resist layer exposed, pure water was allowed to drip onto the resist layer at 23 degrees C for 2 minutes. Subsequently, the resist film was subjected to PEB treatment at 100 degrees C for 90 seconds, and subjected to development using an alkaline developer solution at 23 degrees C for 60 seconds. As the alkaline developer solution, a 2.38 mass% tetramethylammonium hydroxide water solution was used.

A resist pattern is formed by using the obtained positive-type resist composition 3 in the same way as Example 1. The obtained resist pattern having a 130 nm 1:1 line and space was individually examined under a scanning electron microscope (SEM), and the sensitivity (Eop) was determined. The Eop(X2) was 21.4 mJ/cm². The resist pattern was poor, due to the T-top formation and surface roughness observed. It was assumed that the T-top formation was caused by rendering a nitrogen-containing organic compound from the resist composition. A resist pattern was formed with the resist composition 3 in the same manner, except that a general exposure lithography process without the simulated immersion lithography process, and Eop (X1) was 20.5 mJ/cm². The ratio of sensitivity in the simulated immersion lithography treatment to the sensitivity in the normal exposure [(X2/X1)-1]×100=[(21.4/20.5)-1]×100 was determined, and the result was 4.39.

From the results of the Examples 1 and 2, the sensitivities in the simulated immersion lithography treatment and the normal exposure treatment are almost same in the resist composition according to the present invention. That is, it is found that the resist composition according to the present invention is a resist composition suitable for formation of a resist pattern by immersion lithography, which is advantageous not only in that the lowering of the sensitivity is small due to a higher contact angle, even when the resist composition is in contact with water, but also the resolving ability and the resist pattern configuration are excellent; for example, neither a T-top formation nor surface roughness are caused. On the other hand, from the results of the Comparative Examples 1, it is found that, in the resist composition using a resin having a fluorine atom other than that of the present invention, the sensitivities in the simulated immersion lithography treatment and in the normal exposure treatment were greatly changed and deteriorated, and the resist pattern was poor due to the T-top formation and the surface roughness observed. Therefore, the resist composition was unsuitable for the immersion lithography.

### Example 3

The component (A), the component (B), and the component (D) shown below were uniformly dissolved in the component (C) to prepare the positive-type resist composition 4. As the component (A), 100 parts by mass of a methacrylate/acrylate copolymer composed of three structural units shown by the following chemical formula (25) was used. The ratio of the constitutional units v, w, and x used for preparing the component (A) was v=50 mol%, w=29 mol% and x=21 mol%. The prepared component (A) had a mass average molecular weight of 11,200 and dispersion degree of 1.5. The contact angle with pure water was 77.7 degrees.

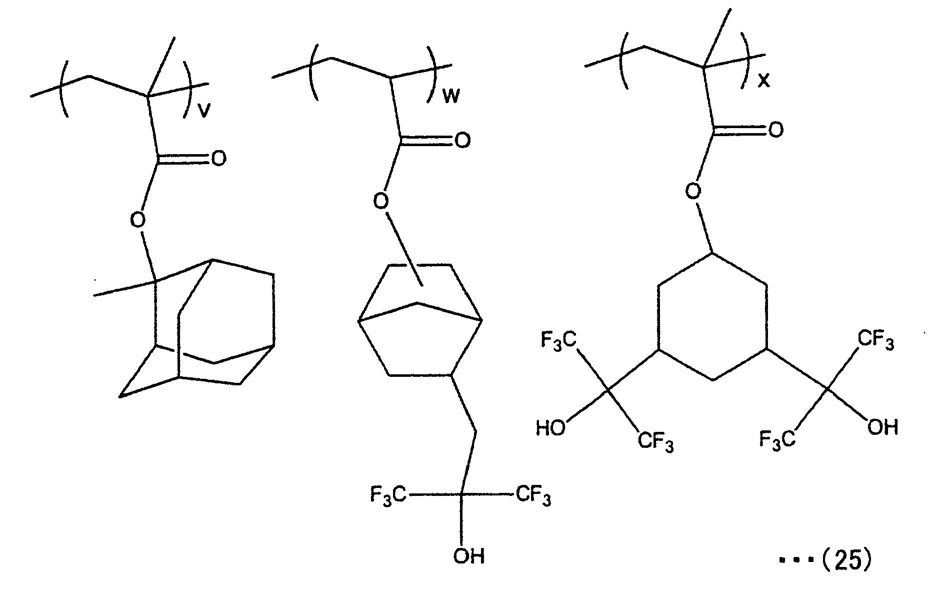

As component (B), 5 parts by mass of triphenylsulfonium nonafluorobutane sulfonate was used. As the component (C), 1600 parts by mass of a mixed solvent of propylene glycol monomethyl ether acetate and ethyl lactate (mass ratio=6:4) was used. As the component (D), 0.98 parts by mass of tris-2-(2-methoxy(ethoxy))ethylamine was used.

A resist pattern was formed by using the obtained positive resist composition 4. An organic anti-reflection coating composition "ARC-29" (trade name, by Brewer Science) was first applied onto a silicon wafer using a spinner, and then dried by calcinations on a hot plate at 215 degrees C for 60 seconds to form an organic anti-reflection coating film having a thickness of 77 nm. Afterwards, the positive resist composition 4 was applied onto the anti-reflection coating film using a spinner, and dried by prebake on a hot plate at 90 degrees C for 90 seconds to form a resist film having a thickness of 150 nm on the anti-reflection coating film. Next, the resist layer was selectively irradiated through a mask pattern with an ArF excimer laser (193 nm) by means of an exposure system (NSR-S302B, by Nikon Corporation; NA (numerical aperture)=0.60, 2/3 annular illumination). In simulated immersion lithography treatment, when rotating the silicon wafer having the resist layer exposed, pure water was allowed to drip onto the resist layer at 23 degrees C for 2 minutes. Subsequently, the resist layer was subjected to PEB treatment at 110 degrees C for 90 seconds, and subjected to development using an alkaline developer solution at 23 degrees C for 60 seconds. As the alkaline developer solution, 2.38 mass% of tetramethylammonium hydroxide water solution was used.

Thus, the formed resist pattern having a 130 nm line and space of 1:1 was examined under a scanning electron microscope (SEM), and its sensitivity (Eop) was determined. In the resist composition 4, Eop (X2) was 20.8 mJ/cm². The resist pattern was excellent, and no T-top formation or surface roughness was observed. A resist pattern was formed with the resist composition 4 in the same manner, except that a general exposure lithography process without the simulated immersion lithography process, and Eop (X1) was 20.0 mJ/cm². The ratio of sensitivity in the simulated immersion lithography treatment to the sensitivity in the normal exposure [(X2/X1)-1]×100=[(20.8/20.0)-1]×100 was determined, and the result was 4.0.

### Example 4

In the resist composition 1, 0.45 mass parts of triethanolamine was replaced with 0.98 mass parts of tris-2-(2-methoxy(ethoxy))ethylamine. In the Evaluation Test 2, using the laboratory equipment prepared by Nikon Corporation, immersion lithography was conducted by 193 nm two-beam interferometry using a prism and water (two-beam interferometry experiment). The test is conducted in the same way, except that the film thickness was 130 nm. The result showed that 65 nm line-and-space (1:1) was resolved.

### Example 5

By using the resist composition 4, in the Evaluation Test 2, using laboratory equipment prepared by Nikon Corporation, the immersion lithography was conducted by 193 nm two-beam interferometry using a prism and water (two-beam interferometry experiment), except that the film thickness was 130 nm. The result showed that a 65 nm 1:1 line-and-space was resolved.

In the immersion lithography in the present Examples 4 and 5, a solvent layer of water as an immersion solvent was formed between the resist layer and the bottom surface of the prism. The exposure energy was selected so that the L&S pattern was consistently obtained. In addition, the Evaluation Test 2 examines the effect to the resist layer on the water solvent, the resolving ability of the resist pattern, and the pattern profile.

### INDUSTRIAL APPLICABILITY

The positive-type resist composition according to the present invention is useful as a positive-type resist composition for liquid immersion lithography, and in particular, it exhibits a superior barrier property to water used as an immersion liquid and a superior resist pattern profile configuration, so that it is suitable for obtaining a high resolving ability.

## Claims

1. A positive-type resist composition for liquid immersion lithography comprising:
a resin component (A), increasing alkali-solubility by acid action; and
an acid generator component (B), generating acid by exposure,
wherein, the resin component (A) contains at least one acrylic ester constitutional unit (a1), and one (meth)acrylic ester constitutional unit (a2) having acid dissociable, dissolution inhibiting group,
the constitutional unit (a1) consisting of a cyclic group bonded to an acrylic ester of the constitutional unit (a1), and a fluoro organic group bonded to the cyclic group, and
the fluoro organic group being formed by at least partially substituting hydrogen atoms of an organic group with fluorine atoms, and having a substituted or unsubstituted alcoholic hydroxyl group.

2. The positive-type resist composition for liquid immersion lithography according to Claim 1, wherein the constitutional unit (a1) is expressed by the following general formula (1), 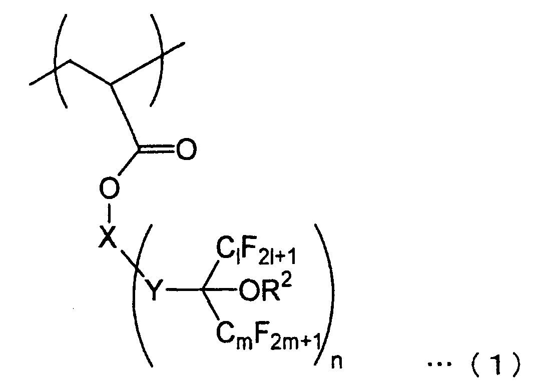 in which, X represents a divalent or trivalent cyclic group; and Y represents a divalent alkylene or alkyloxy group having 1 to 6 carbons; R² represents a hydrogen atom, a chain, a branched or a cyclic alkyloxymethyl group having 1 to 15 carbons; 1 and m respectively, are integers from 1 to 5; and n is an integer of 1 or 2.

3. The positive-type resist composition for liquid immersion lithography according to Claim 1 or 2, wherein the constitutional unit (a2) is expressed by the following general formula (2), 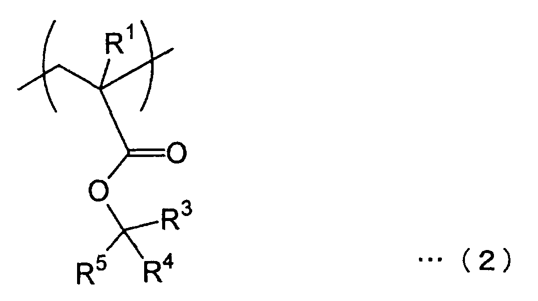 in which, R¹ represents a hydrogen atom or a methyl group; R³ to R⁵ represents an alkyl group having 1 to 10 carbons, which may be the same or different from each other; and at least two alkyl groups among these may bind to form the cyclic groups.

4. The positive-type resist composition for liquid immersion lithography according to any one of Claims 1 to 3, wherein the resin component (A) further comprises: one or more constitutional units (a3), which are different from the constitutional units (a1) and (a2).

5. The positive-type resist composition for liquid immersion lithography according to Claim 4, wherein the unit (a3) is the constitutional unit (a4) induced from a (meth)acrylic acid having a monocyclic or a polycyclic group containing lactone.

6. The positive-type resist composition for liquid immersion lithography according to Claim 4, wherein the unit (a3) is expressed by the general formula (3), 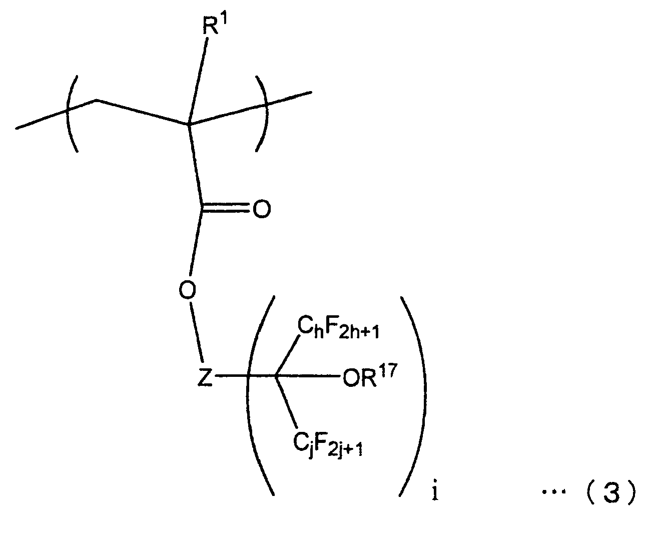 in which, Z represents a divalent or a trivalent cyclic group; R¹ represents a hydrogen atom or a methyl group; R¹⁷ represents a hydrogen atom, a chain, a branched or a cyclic alkyloxymethyl group having 1 to 15 carbons; and h and j respectively, are integers from 1 to 5; and i is an integer of 1 or 2.

7. The positive-type resist composition for liquid immersion lithography according to any one of Claims 1 to 6, wherein a cyclic group in the constitutional unit (a1) is an aliphatic cyclic group.

8. The resist composition for liquid immersion lithography according to Claim 7, wherein the alicyclic group is a polycyclic aliphatic hydrocarbon group.

9. The resist composition for liquid immersion lithography according to Claim 8, wherein the polycyclic aliphatic hydrocarbon group is a norbolnyl group.

10. The resist composition for liquid immersion lithography according to any one of Claims 1 to 9, wherein an acid dissociable, dissolution inhibiting group in the constitutional unit (a2) is a polycyclic aliphatic hydrocarbon group.

11. The resist composition for liquid immersion lithography according to Claim 10, wherein the polycyclic aliphatic hydrocarbon group is an adamanthyl group.

12. The resist composition for liquid immersion lithography according to any one of Claims 1 to 11, wherein a medium for liquid immersion lithography is water.

13. A method for forming a resist pattern using a liquid immersion lithography process comprising the steps of:
forming a photoresist film onto a substrate by using at least the positive-type resist composition according to any one of Claims 1 to 12;
disposing an immersion solvent onto the substrate on which the resist film is laminated;
selectively exposing the resist film via the immersion fluid;
conducting a heat process as required; and
developing the resist film.
